# FASCICULE DE BREVET EUROPEEN

(11) **EP 3 392 918 B1**
(45) Date de publication et mention de la délivrance du brevet: **13.05.2020**
(21) Numéro de dépôt: 18167095.1
(22) Date de dépôt: 12.04.2018
(51) Int. Cl.: H01L 33/08, H01L 25/075, H01L 27/15

(54) **PROCEDE DE REALISATION D'UN DISPOSITIF D'AFFICHAGE A MATRICE DE LEDS**
VERFAHREN ZUR HERSTULLUNG EINER LED-MATRIX-ANZEIGEVORRICHTUNG
METHOD OF MANUFACTURING A LED MATRIX DISPLAY DEVICE

(30) Priorité: 18.04.2017 FR 1753334
(43) Date de publication de la demande: 24.10.2018
(73) Titulaire: Commissariat à l'énergie atomique et aux énergies alternatives, 75015 Paris (FR)
(72) Inventeur: ROBIN, Ivan-Christophe, 38000 GRENOBLE (FR); BONO, Hubert, 38000 GRENOBLE (FR); VINET, Maud, 38640 CLAIX (FR)
(74) Mandataire: Brevalex

(56) Documents cités:
- WO-A1-2016/188505
- US-A1- 2015 325 598
- US-A1- 2016 268 488

## Description

### DOMAINE TECHNIQUE ET ART ANTÉRIEUR

L'invention concerne le domaine des dispositifs d'affichage à LEDs (« Light-Emitting Diode », ou diode électroluminescente), et notamment celui des micro-écrans à microLEDs (µLEDs).

Pour la fabrication d'un micro-écran à forte luminance, une approche consiste à utiliser une matrice de LEDs réalisées à partir de GaN, d'InGaN, d'InGaP ou encore d'InGaAIP, chacune ayant des dimensions, dans un plan sensiblement parallèle à la surface d'émission des LEDs, de l'ordre de 10 µm. Chacune des LEDs est adressée individuellement par un circuit électronique de commande auquel la matrice de LEDs est couplée.

De manière générale, le circuit électronique de commande intègre des transistors FET (transistors à effet de champ, par exemple de type MOSFET) réalisés dans une couche active de semi-conducteur tel que du silicium. Un tel circuit électronique de commande comporte par exemple, pour la commande de chacune des LEDs, un ou deux transistors FET commandés via un adressage matriciel.

Dans le cas de LEDs réalisées à base de nitrure, la tension d'alimentation nécessaire aux transistors est d'environ 5 V. La résistance à l'état passant requise pour ces transistors est faible, généralement inférieure à environ 10 kΩ pour une surface de l'ordre de 1 µm². Une faible dispersion (de l'ordre de moins de 1 %) sur la tension de seuil Vt des transistors est également requise. De telles performances peuvent également être requises pour d'autres types de transistors.

Pour remplir ces critères, les transistors du circuit électronique de commande sont généralement réalisés dans une couche active de silicium monocristallin. Les procédés classiques de réalisation des transistors comportent des étapes impliquant des budgets thermiques importants, pouvant atteindre par exemple des températures de l'ordre de 1000°C. Or, la matrice de LEDs ne peut supporter de telles températures.

Pour répondre à ce problème et ne pas exposer la matrice de LEDs à de telles températures, un couplage entre un circuit électronique de commande déjà réalisé et la matrice de LEDs également réalisée peut être effectué en reportant de manière alignée et en hybridant le circuit électronique de commande sur la matrice de LEDs, via l'utilisation de micro-tubes.

Bien que cette solution évite d'exposer la matrice de LEDs à des température trop importantes, les composants électroniques du circuit électronique de commande associés à chaque pixel de la matrice de LEDs doivent être alignés avec la LED de ce pixel avec une précision inférieure à environ 1 µm. Ce report est donc complexe à mettre en œuvre en raison des très nombreuses connexions (par exemple de l'ordre de 10⁶) à aligner et à réaliser lors de ce report entre la matrice de LEDs et le circuit de commande électronique. En outre, il est très difficile de réaliser des micro-tubes avec des dimensions aussi faibles.

Enfin, les différents coefficients d'expansion thermique des matériaux à hybrider représentent une contrainte importante à gérer lors de cette hybridation. En effet, du fait que l'hybridation est réalisée à une température par exemple supérieure à environ 100°C, les différences de coefficient d'expansion thermique entre les matériaux accentuent le décalage d'alignement, notamment en périphérie de ces éléments. De plus, il apparait au refroidissement une contrainte thermique qui peut aller jusqu'à la rupture de l'ensemble des substrats.

Le document US 2015/0325598 A1 divulgue un procédé de fabrication d'un dispositif d'affichage à LEDs comprenant un circuit de commande à transistors FET formé par wafer bonding.

### EXPOSÉ DE L'INVENTION

Un but de la présente invention est de proposer un procédé de réalisation d'un dispositif d'affichage à matrice de LEDs ne présentant pas les inconvénients des procédés de l'art antérieur, c'est-à-dire évitant l'exposition de la matrice de LEDs à des température trop importantes tout en supprimant les problèmes d'alignement et de connexion rencontrés lors d'un report et d'une hybridation du circuit électronique de commande sur la matrice de LEDs via des micro-tubes et/ou en présence de matériaux ayant différents coefficients d'expansion thermique.

Pour cela, la présente invention propose un procédé de réalisation d'un dispositif d'affichage, comportant au moins la mise en œuvre des étapes suivantes :
- réalisation d'une matrice de LEDs comportant chacune des électrodes accessibles depuis une face arrière de la matrice de LEDs et des surfaces d'émission lumineuse depuis une face avant de la matrice de LEDs ;
- solidarisation, sur la face arrière de la matrice de LEDs, d'un empilement de couches comprenant au moins une couche de semi-conducteur, une couche de diélectrique de grille et une couche de matériau conducteur de grille ;
- réalisation, à partir de l'empilement de couches, d'un circuit électronique de commande couplé électriquement aux électrodes des LEDs, comprenant la réalisation de transistors FET comprenant des zones actives et des grilles, les zones actives étant formées dans la couche de semi-conducteur et les grilles étant formées dans les couches de diélectrique de grille et de matériau conducteur de grille.

Du fait que les matériaux servant à la réalisation des grilles des transistors du circuit électronique de commande (c'est-à-dire les couches de diélectrique de grille et de matériau conducteur de grille) sont déjà présents dans l'empilement de couches reporté sur la matrice de LEDs, cette matrice de LEDs n'est pas exposée aux températures importantes rencontrées lors des dépôts de ces matériaux, comme par exemple la formation du diélectrique de grille par oxydation qui met en jeu des températures supérieures à environ 700°C ou 800°C.

En outre, ce procédé s'affranchit des contraintes d'alignement du fait que dans ce procédé faisant appel à plusieurs substrats (au moins un premier substrat pour la réalisation de la matrice de LEDs et un deuxième substrat sur lequel est formé l'empilement de couches servant à la réalisation du circuit électronique de commande) intégrés séquentiellement, le circuit électronique de commande est réalisé après avoir reporté l'empilement de couches servant à sa réalisation sur la face arrière de la matrice de LEDs. Ainsi, l'alignement peut être réalisé facilement au moment de la lithographie des transistors et non au moment de la solidarisation de l'empilement de couches avec la matrice de LEDs. La précision des étapes mises en œuvre pour positionner et réaliser les transistors FET sur la face arrière des LEDs grâce à la lithographie mise en œuvre est par exemple de l'ordre de 5 nm pour une lithographie avancée de type DUV (UV profonde). Cette précision lithographique est bien supérieure à la précision pouvant être atteinte avec un procédé comprenant une solidarisation mise en œuvre après avoir réalisés individuellement les matrices de LEDs et les circuits de commande (précision supérieure à 1µm).

Cet excellent alignement obtenu entre la matrice de LEDs et le circuit électronique de commande autorise également de réaliser le circuit électronique de commande avec de très fortes densités de transistors, par exemple au moins huit transistors par LED lorsque le circuit électronique de commande ne comporte pas de capacités, ou au moins quatre transistors pour des LEDs adressées par PWM (« Pulse Width Modulation », ou modulation de largeur d'impulsion).

Le fait de réaliser le circuit électronique de commande après avoir reporté l'empilement de couches sur la face arrière de la matrice de LEDs réduit les problèmes liés à la solidarisation entre des matériaux ayant des coefficients d'expansion thermique différents.

En outre, le fait que les électrodes des LEDs soient accessibles depuis la face arrière de la matrice et que les surfaces d'émission des LEDs se trouvent en face avant de la matrice permet de ne pas avoir de masquage de l'émission lumineuse des LEDs par les électrodes

L'expression « couche de diélectrique de grille » désigne au moins une couche d'au moins un matériau configurée pour former les diélectriques de grille des transistors FET.

L'expression « couche de matériau conducteur de grille » désigne au moins une couche d'au moins un matériau configurée pour former les conducteurs de grille des transistors FET.

Selon une première variante, le matériau diélectrique de grille peut correspondre à un matériau diélectrique à forte permittivité, également appelé diélectrique « high-k » (permittivité diélectrique relative supérieure à celle du SiO₂, c'est-à-dire supérieure à 3,9), comme par exemple du HfO₂, et le matériau conducteur de grille peut correspondre à un métal.

Selon une deuxième variante, le matériau diélectrique de grille peut correspondre à un oxyde tel que du SiO₂ et le matériau conducteur de grille peut correspondre à du polysilicium.

La réalisation de la matrice de LEDs peut comporter la mise en œuvre des étapes suivantes, pour chacune des LEDs :
- réalisation d'une structure mesa comprenant au moins des première et deuxième portions de semi-conducteur de dopages différents et formant une jonction p-n ;
- réalisation d'une première électrode disposée sur la structure mesa et couplée, ou reliée, électriquement à la première portion de semi-conducteur ;
- réalisation d'une deuxième électrode disposée à côté de la structure mesa et couplée, ou reliée, électriquement à la deuxième portion de semi-conducteur par l'intermédiaire d'au moins une partie des faces latérales de la deuxième portion de semi-conducteur.

La première portion de semi-conducteur peut correspondre à celle se trouvant du côté de la face arrière de la matrice de LEDs

La deuxième électrode peut être isolée électriquement vis-à-vis de la première portion de semi-conducteur par des portions diélectriques recouvrant au moins les flancs latéraux de la première portion de semi-conducteur. Cette localisation des portions d'isolation électrique uniquement sur les flancs latéraux de la structure mesa de chaque LED permet d'améliorer le rapport entre la surface active des LEDs (surface occupée par les jonctions p-n) et la surface totale sur laquelle les LEDs sont réalisées, et donc d'augmenter l'intégration de ces LEDs étant donné le faible encombrement des portions d'isolation électrique de cette structure qui sont strictement verticales (parallèles aux flancs latéraux des structures mesa des LEDs). De plus, cette forte intégration des portions d'isolation électrique a également pour avantage de minimiser les densités de courant obtenues dans les électrodes des LEDs, et donc de réduire l'échauffement par effet Joule au sein du dispositif d'affichage.

Cette structure permet également d'avoir un très bon contact électrique entre la deuxième électrode et les jonctions p-n des LEDs, et optimise ainsi les résistances d'accès du côté de cette deuxième électrode.

L'expression « structure mesa » désigne le fait que les LEDs sont réalisées sous la forme d'un empilement d'un semi-conducteur d'un premier type de conductivité, par exemple de type n, et d'un semi-conducteur d'un second type de conductivité, opposé au premier type de conductivité, par exemple de type p, une zone de jonction étant présente entre ces deux semi-conducteurs, et que cet empilement est gravé sur au moins une partie de sa hauteur sous forme d'îlots afin de rendre accessible le semi-conducteur du premier type de conductivité. Ces îlots sont appelés mésas.

La couche de semi-conducteur servant à la réalisation des zones actives des transistors du circuit électronique de commande peut comporter du SiGe avec une teneur en germanium comprise entre environ 10 % et 50 %. Cette teneur en germanium peut avantageusement être comprise entre environ 30 % et 40 %, par exemple égale à environ 34 %, ce qui permet d'avoir un bon compromis entre la vitesse de recristallisation lors d'une recristallisation des source et drain des transistors et la simplicité du procédé de réalisation. Cette teneur en germanium avantageuse permet en outre de réduire la température maximale atteinte lors du procédé de fabrication du circuit de commande car la température à laquelle un recuit de recristallisation des source et drain des transistors est mis en œuvre est réduite lorsque le pourcentage de Ge dans le canal est important.

La solidarisation de l'empilement de couches sur la face arrière de la matrice de LEDs peut comporter la mise en œuvre d'un collage direct entre une première couche d'oxyde faisant partie de l'empilement de couches et une deuxième couche d'oxyde disposée sur la face arrière de la matrice de LEDs. Avec un tel collage direct entre l'empilement de couches et la matrice de LEDs, il est réalisé une intégration hétérogène à froid des couches de l'empilement de grille des transistors car il peut être mis en œuvre à une température comprise entre la température ambiante et environ 400°C, contrairement aux procédés de l'art antérieur qui impose la mise en œuvre d'une solidarisation circuit électronique - matrice LEDs à des températures plus importantes et qui pose alors des problèmes en raisons des matériaux à coefficients d'expansion thermique différents qui sont en contact les uns avec les autres.

Le collage direct entre l'empilement de couches et la matrice de LEDs peut être réalisé autrement que par un collage oxyde - oxyde, par exemple via des couches de SiO₂ planarisées par polissage mécano-chimique.

Lors d'un collage direct oxyde - oxyde, le procédé peut comporter en outre, avant la solidarisation de l'empilement de couches (servant à la réalisation du circuit électronique de commande) sur la face arrière de la matrice de LEDs, la réalisation de l'empilement de couches par la mise en œuvre des étapes suivantes :
- réalisation de la couche de diélectrique de grille sur la couche de semi-conducteur qui correspond à la couche superficielle d'un substrat de type semi-conducteur sur isolant, par exemple SOI (« Silicon On Insulator », ou silicium sur isolant) ;
- réalisation de la couche de matériau conducteur de grille sur la couche de diélectrique de grille ;
- réalisation d'une couche de masque dur sur la couche de matériau conducteur de grille ;
- réalisation d'une couche de maintien mécanique sur la couche de masque dur ;
- suppression d'une couche épaisse, ou massive, de semi-conducteur du substrat de type semi-conducteur sur isolant ;
et dans lequel une couche diélectrique enterrée, ou BOX (« Buried Oxide ») du substrat de type semi-conducteur sur isolant peut former la première couche d'oxyde destinée à la mise en œuvre du collage direct.

La couche de semi-conducteur de l'empilement de couches peut comporter un semi-conducteur cristallin, et les zones actives des transistors FET peuvent être formées dans la couche de semi-conducteur au moins via la mise en œuvre d'une implantation ionique dans des parties des zones actives des transistors FET destinées à former les source et drain des transistors FET, rendant partiellement amorphe le semi-conducteur desdites parties, puis d'un recuit de recristallisation en phase solide des zones actives des transistors FET.

L'implantation ionique est ici mise en œuvre telle qu'une partie de l'épaisseur des parties de zones actives implantées reste cristalline et forme, lors du recuit de recristallisation, un germe de recristallisation des source et drain des transistors FET. Pour cela, l'énergie et la dose utilisées lors de l'implantation ionique peuvent être adaptées pour qu'il reste une partie de semi-conducteur cristallin au sein des source et drain à l'issue de cette implantation.

Le recuit de recristallisation peut être mis en œuvre à une température comprise entre environ 450°C et 600°C.

En réalisant les source et drain par amorphisation partielle suivie d'un recuit de recristallisation, le circuit électronique de commande est obtenu sans mettre en œuvre de techniques impliquant des budgets thermiques importants.

Le recuit de recristallisation peut être mis en œuvre de manière classique dans un four. De manière alternative, le recuit de recristallisation peut être mis en œuvre en exposant les source et drain des transistors FET à une source laser, ce qui permet de confiner la chaleur apportée par la source laser dans les couches servant à la réalisation de ces source et drain.

La réalisation des transistors FET peut comporter la mise en œuvre des étapes suivantes :
- lithographie et gravure des couches de diélectrique de grille et de matériau conducteur de grille et de la couche de semi-conducteur telles que des portions restantes de la couche de semi-conducteur forment les zones actives des transistors FET ;
- lithographie et gravure des couches de diélectrique de grille et de matériau conducteur de grille telles que des portions restantes des couches de diélectrique de grille et de matériau conducteur de grille forment les grilles des transistors FET ;
- réalisation d'espaceurs contre des parois latérales des grilles des transistors FET ;
et les parties des zones actives des transistors FET destinées à former les source et drain des transistors FET correspondent à des parties des zones actives des transistors FET non recouvertes par les grilles et les espaceurs.

La réalisation du circuit électronique de commande peut comporter en outre, après la réalisation des transistors FET, la réalisation de contacts électriques couplées, ou reliés, électriquement aux transistors FET (notamment aux contacts de grille, de source et de drain) et/ou aux électrodes des LEDs. Ces contacts électriques peuvent être réalisés au sein d'un ou plusieurs niveaux métalliques formés sur la face arrière de la matrice de LEDs.

Le procédé peut comporter en outre, entre la solidarisation de l'empilement de couches sur la face arrière de la matrice de LEDs et la réalisation du circuit électronique de commande, la mise en œuvre des étapes suivantes :
- réalisation de cavités à travers une face d'une couche capot, chaque cavité étant destinée à être disposée en regard d'une des LEDs ;
- dépôt d'un matériau réflecteur au moins contre des parois latérales intérieures des cavités ;
- solidarisation de ladite face de la couche capot contre la face avant de la matrice de LEDs telle que chaque cavité soit disposée en regard d'au moins une des LEDs;
et le procédé peut comporter en outre, après la réalisation du circuit électronique de commande, une étape d'amincissement de la couche capot supprimant des parois de fond des cavités de la couche capot se trouvant en regard des surfaces d'émission lumineuse des LEDs.

Ainsi, on forme entre les surfaces d'émission lumineuse de LEDs voisines des éléments réflecteurs permettant de limiter la diaphonie, ou « crosstalk », entre ces LEDs.

Le procédé fait dans ce cas appel à trois substrats distincts intégrés séquentiellement pour réaliser le dispositif d'affichage.

Le procédé peut comporter en outre, après l'étape d'amincissement de la couche capot, une étape de réalisation de luminophores entre les portions restantes de la couche capot, contre la face avant de la matrice de LEDs et en regard des surfaces d'émission des LEDs. Ainsi, il est possible d'ajuster et/ou modifier la gamme de longueurs d'ondes de la lumière émise par les LEDs. Ces luminophores peuvent être différents d'une LED à l'autre.

En variante, le procédé peut comporter en outre, entre la solidarisation de l'empilement de couches sur la face arrière de la matrice de LEDs et la réalisation du circuit électronique de commande, la réalisation d'une structure de filtrage optique apte à filtrer au moins une partie des longueurs d'onde destinées à être émises par au moins une partie des LEDs, sur la face avant de la matrice de LEDs et en regard des surfaces d'émission lumineuse de ladite partie des LEDs.

Dans ce cas, la réalisation de la structure de filtrage optique peut comporter au moins la mise en œuvre des étapes suivantes :
- dépôt d'une couche d'un premier matériau de filtrage sur la face avant de la matrice de LEDs ;
- gravure de la couche du premier matériau de filtrage telle que des portions restantes du premier matériau de filtrage soient disposées en regard des surfaces d'émission lumineuse d'une partie des LEDs, appelées premières LEDs ;
- réalisation de premières portions de matériau diélectrique transparent entre les portions restantes du premier matériau de filtrage ;
- dépôt d'une deuxième couche de matériau de filtrage sur les portions restantes du premier matériau de filtrage et sur les premières portions de matériau diélectrique transparent ;
- gravure de la deuxième couche de matériau de filtrage telle que des portions restantes du deuxième matériau de filtrage soient disposées en regard de surfaces d'émission d'autres LEDs, appelées deuxième LEDs ;
- réalisation de deuxièmes portions de matériau diélectrique transparent entre les portions restantes du deuxième matériau de filtrage ;
et le procédé peut comporter en outre un dépôt d'une couche de maintien mécanique optiquement transparente contre la structure de filtrage optique préalablement à la réalisation du circuit électronique de commande.

Ainsi, il est possible de réaliser, sur la face avant de la matrice de LEDs, des portions de matériau de filtrage modifiant la gamme de longueurs d'ondes émises par les LEDs. Ces matériaux de filtrage peuvent être différents d'une LED à l'autre. De plus, ne nombre de matériau de filtrage différents formés dans la structure de filtrage optique peut être différent de deux (cas de l'exemple donné ci-dessus), et être plus généralement supérieur ou égal à 1.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A - 1G représentent les étapes mises en œuvre pour la réalisation d'une matrice de LEDs d'un dispositif d'affichage, objet de la présente invention, selon un mode de réalisation particulier;
- les figures 2A - 2C représentent les étapes mises en œuvre pour la réalisation et le report d'un empilement de couches sur une matrice de LEDs d'un dispositif d'affichage, objet de la présente invention, selon un mode de réalisation particulier ;
- les figures 3A - 3D représentent les étapes mises en œuvre pour la réalisation et la solidarisation d'une couche capot contre une matrice de LEDs d'un dispositif d'affichage, objet de la présente invention, selon un mode de réalisation particulier ;
- les figures 4A - 4D représentent les étapes mises en œuvre pour former les transistors FET du circuit électronique de commande d'un dispositif d'affichage, objet de la présente invention, selon un mode de réalisation particulier ;
- la figure 4E représente un exemple de réalisation d'une partie d'un circuit électronique de commande d'un dispositif d'affichage, objet de la présente invention, selon un mode de réalisation particulier;
- les figures 4F et 4G représentent des étapes mises en œuvre lors de la réalisation de luminophores d'un dispositif d'affichage, objet de la présente invention, selon un mode de réalisation particulier ;
- les figures 5A - 5D représentent les étapes mises en œuvre pour former une structure de filtrage optique d'un dispositif d'affichage, objet de la présente invention, selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

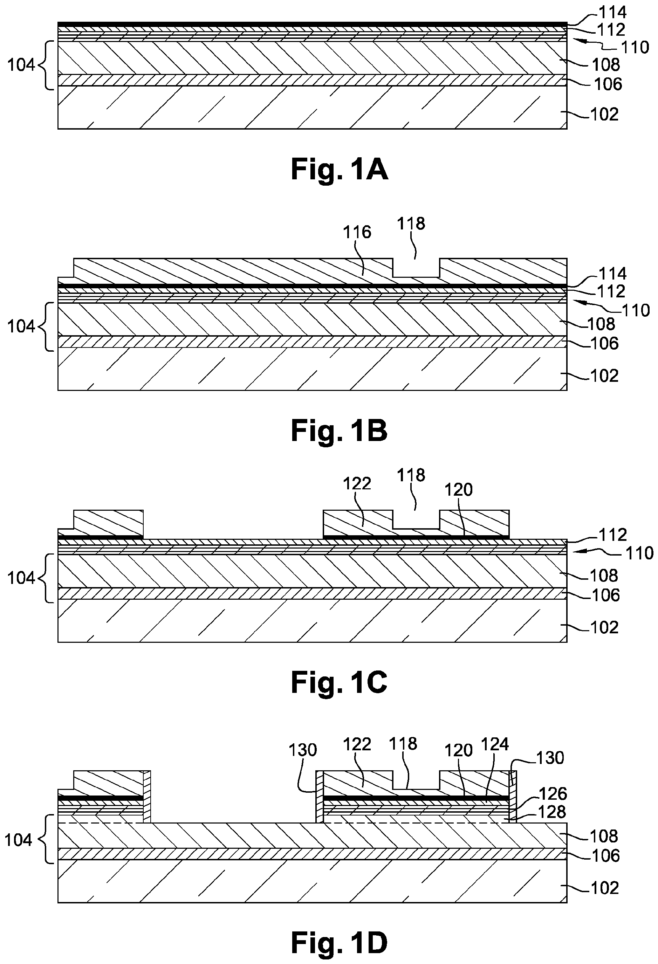

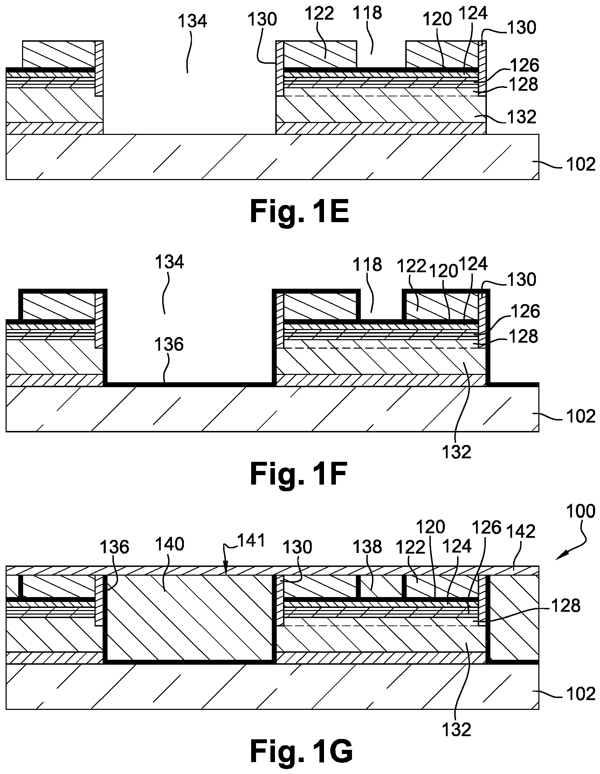

On se réfère tout d'abord aux figures 1A à 1G qui représentent les étapes mises en œuvre pour réaliser une matrice de LEDs 100, qui correspondent ici à des microLEDs, destinée à servir à la réalisation d'un dispositif d'affichage 1000 par exemple du type micro-afficheur. Cette matrice de LEDs 100 est destinée à former une matrice de pixels du dispositif d'affichage 1000. Sur ces figures, une seule LED 100 est représentée entièrement.

Les LEDs 100 sont réalisées à partir de couches formées sur un substrat 102, comprenant par exemple du silicium, de l'Al₂O₃ ou du saphir, et destiné à servir de support pour la croissance de ces couches. Comme représenté sur la figure 1A, ces couches formées sur le substrat 102 correspondent à une couche de semi-conducteur dopé n 104, par exemple du GaN. Cette couche 104 comprend une première partie 106 de type n et une deuxième partie 108 dopée n. En variante, ces deux parties 106, 108 de la couche 104 peuvent correspondre à deux couches de matériaux différents, avec par exemple la première partie 106 comprenant du GaN et la deuxième partie 108 comprenant de l'InGaN. Selon une autre variante, que les deux parties 106, 108 correspondent à deux couches de matériaux différents ou à une seule couche d'un même matériau, les niveaux de dopage des deux parties 106, 108 peuvent être similaires ou non.

La première partie 106 de la couche 104 correspond par exemple une couche buffer comprenant un semi-conducteur non intentionnellement dopé, et dont le rôle est de permettre une croissance, sur celle-ci, de semi-conducteur avec une bonne qualité cristalline. La concentration de donneurs dans la première partie 106 est par exemple de l'ordre de 10¹⁷ donneurs/cm³. La deuxième partie 108 de la couche 104 correspond par exemple à une portion de semi-conducteur intentionnellement dopée de type n avec une concentration de donneurs par exemple comprise entre environ 10¹⁸ et 10²⁰ donneurs/cm³.

L'épaisseur de la couche 104 est par exemple comprise entre environ 20 nm et 10 µm.

Les couches formées sur le substrat 102 comportent également, sur la couche 104, plusieurs couches 110 destinées à former les zones actives émissives des LEDs 100. Les couches 110 correspondent à une ou plusieurs couches émissives formant chacune un puits quantique, comprenant par exemple de l'InGaN, et étant chacune disposée entre deux couches barrières comprenant par exemple du GaN. Les couches 110, c'est-à-dire la ou les couches émissives et les couches barrières, comportent des matériaux semi-conducteurs intrinsèques, c'est-à-dire non intentionnellement dopés (de concentration en donneurs résiduels n_{nid} par exemple égale à environ 10¹⁷ donneurs/cm³, ou comprise entre environ 10¹⁵ et 10¹⁸ donneurs/cm³). L'épaisseur de la ou de chacune des couches émissives est par exemple égale à environ 3 nm et plus généralement comprise entre environ 0,5 nm et 10 nm, et l'épaisseur de chacune des couches barrières est par exemple comprise entre environ 1 nm et 25 nm. Le nombre de puits quantiques formés par les couches 110 est par exemple compris entre environ 1 et 50.

Une couche de semi-conducteur dopé p 112 est disposée sur les couches 110 et est destinée à former, avec la couche 104, les jonctions p-n des LEDs 100. Comme la couche 104, le semi-conducteur de la couche 112 est par exemple du GaN. Le dopage p de la couche 112 correspond par exemple à une concentration d'accepteurs comprise entre environ 10¹⁷ et 10²⁰ accepteurs/cm³. L'épaisseur de la couche 112 est par exemple comprise entre environ 20 nm et 10 µm.

Une couche électriquement conductrice 114 est ensuite formée sur la couche 112, et est destinée à former une partie des électrodes de contact des régions p des LEDs 100, c'est-à-dire les anodes. La couche 114 est optiquement réflectrice, c'est-à-dire est apte à réfléchir une majeure partie (par exemple au moins 80 %) de la lumière arrivant sur celle-ci et qui correspond à la lumière émise depuis les zones actives émissives des LEDs 100 et qui est destinée à être émise par les LEDs 100. La couche 114 comporte par exemple de l'aluminium et/ou de l'argent, ou plus généralement tout matériau électriquement conducteur et optiquement réflecteur, et son épaisseur est par exemple comprise entre environ 50 nm et 1 µm.

Une couche 116 destinée à servir à la réalisation d'un masque dur est ensuite formée sur la couche 114 (figure 1B). Une première gravure est mise en œuvre à travers une partie de l'épaisseur de la couche 116, définissant des emplacements 118 pour les anodes des LEDs 100.

Une lithographie et une gravure sont ensuite mises en œuvre afin de structurer la couche 116 selon le motif de masque dur 122 souhaité, permettant de former ensuite par gravure, dans la couche 114, des portions 120 chacune destinée à former une partie de l'électrode de contact de la région p de l'une des LEDs 100 (figure 1C). Le motif de cette gravure correspond à celui d'une structure mesa, c'est-à-dire un empilement sous forme d'îlot, que chacune des LEDs 100 est destinée à former. Chaque structure mesa de chaque LED 100 a par exemple une section, dans un plan parallèle à la face de la couche 112 sur laquelle reposent les portions 120, en forme de disque. Chacune des structures mesa peut donc former un îlot de forme cylindrique. Chacune des portions 120 est recouverte par une portion du masque dur 122 dans laquelle l'un des emplacements 118 est présent. Le matériau du masque dur 122 (et donc de la couche 116) est avantageusement un diélectrique réalisant une passivation des portions 120, comme par exemple du SiO₂.

Cette gravure selon le motif du masque dur 122, et donc selon le motif des structures mesa des LEDs 100, est ensuite prolongée dans les couches 112, 110 et une partie de l'épaisseur de la couche 104, formant pour chaque LED 100 une portion restante 124 de semi-conducteur dopé p, une ou plusieurs zones actives émissives 126 et une portion 128 de semi-conducteur dopé n. Cette gravure est par exemple de type RIE ICP chloré, c'est-à-dire une gravure ionique réactive. Cette gravure est stoppée à un niveau de profondeur situé dans la couche 104, c'est à dire telle qu'une portion de cette couche 104 soit conservée à l'aplomb de chacune des zones gravées de l'empilement. Lorsque la couche 104 est formée des deux parties 106 et 108, la portion de la couche 104 qui est conservée au niveau de chacune des zones gravées de l'empilement comporte au moins une portion de la partie 106. Sur l'exemple de la figure 1D, cette gravure est stoppée à un niveau se trouvant dans la partie 108 de la couche 104 telle que la partie 106 et une partie de l'épaisseur de la partie 108 ne soient pas gravées. L'épaisseur de matériau gravée de la couche 104 est par exemple comprise entre environ 200 nm et 5 µm, et dépend de l'épaisseur initiale de la couche 104. En variante, cette gravure peut être stoppée au niveau de la face supérieure de la partie 106, c'est-à-dire à travers toute l'épaisseur de la partie 108 et telle que la partie 106 ne soit pas gravée. Selon une autre variante, cette gravure peut être stoppée à un niveau se situant dans la partie 106 telle que seule une partie de l'épaisseur de la partie 106 ne soit pas gravée.

Le choix de la profondeur de cette gravure dépend du choix de la hauteur des flancs latéraux de la structure mesa destinés à être recouverts par des portions diélectriques 130 formées ensuite contre les flancs latéraux des parties gravées des couches de l'empilement (voir figure 1D). Ces portions diélectriques 130 recouvrent donc ici uniquement les flancs latéraux des portions 122, 120, 124 et 128 et les zones actives émissives 126.

Les portions diélectriques 130 sont par exemple réalisées en déposant tout d'abord une couche de passivation, comprenant par exemple du SiN, avec une épaisseur conforme par exemple comprise entre environ 3 nm et 100 nm, sur les portions 122, le long des parois latérales des structures mesas (formées par les éléments 122, 120, 124, 126 et 128), ainsi que sur les parties non gravées de la couche 104. Une gravure anisotrope, par exemple une gravure sèche, est ensuite mise en œuvre telle que seules les parties de cette couche recouvrant les flancs latéraux des structures mesas soient conservées et forment les portions diélectriques 130.

La gravure de la couche 104 est ensuite prolongée à travers l'épaisseur restante de cette couche, selon le motif défini par les portions 122 et par les portions diélectriques 130 et formant, pour chacune des LEDs 100, une portion restante 132 de la couche 104 disposée sous la portion 128 et sous les portions diélectriques 130. Contrairement à la portion 128 dont les flancs latéraux sont recouverts par les portions diélectriques 130, ceux de la portion 132 ne sont pas recouverts par les portions diélectriques 130. Cette gravure est par exemple de type RIE ICP chloré. Cette gravure est stoppée sur la face avant du substrat 102.

Cette gravure forme des espaces 134 entre les structures mesas voisines des LEDs 100 et qui sont destinés à la réalisation des cathodes des LEDs 100. La distance entre deux structures mesa de LEDs 100 voisines est par exemple supérieure ou égale à environ 50 nm. La distance minimale entre deux structures mesa de LEDs 100 voisines est définie par la résolution minimale de la lithographie mise en œuvre.

Comme représenté sur la figures 1E, la première gravure précédemment mise en œuvre à travers une partie de l'épaisseur de la couche 116 et définissant les emplacements 118 est prolongée à travers le reste de l'épaisseur des portions du masque dur 122 afin que les emplacements 118 forment des accès aux portions conductrices 120. Ces accès sont ici réalisés en deux étapes de gravure afin que la lithographie définissant les emplacements 118 soit réalisée sur une surface plane, ce qui permet d'atteindre la résolution souhaitée. Ces emplacements 118 sont destinés à la réalisation des anodes des LEDs 100.

Une couche électriquement conductrice 136 est ensuite déposée dans les espaces 134, sur les structures mesas, contre les flancs latéraux de ces structures mesa et enfin dans les emplacements 118. Cette couche 136 est notamment destinée à former une couche de contact pour les cathodes des LEDs 100, au niveau des flancs latéraux des portions 132. La couche 136 correspond de préférence à un empilement de plusieurs matériaux : titane, aluminium, ainsi que d'une couche de croissance pour le dépôt ultérieur du ou des matériaux conducteurs des anodes et cathodes des LEDs 100, cette couche de croissance correspondant par exemple à un empilement Ti/TiN/Cu.

Les LEDs 100 sont achevées en réalisant un dépôt, par exemple électrochimique, d'un matériau conducteur tel que du cuivre, sur une épaisseur telle que les espaces 134 soient remplis de ce matériau. Ce matériau remplit également les emplacements 118 des anodes. Une planarisation mécano-chimique de ce matériau, ainsi que des parties de la couche 136 se trouvant sur les portions 122, est ensuite mise en œuvre avec arrêt sur le masque dur 122, formant ainsi, pour chaque LED 100, une anode 138 et une cathode 140. Les anodes 138 sont isolées électriquement des cathodes 140 grâce aux portions du masque dur 122 entourant chacune des anodes 138. Les cathodes 140 sont reliées, ou couplées, électriquement aux portions 132 dont les flancs latéraux ne sont pas recouverts par les portions diélectriques 130.

Les LEDs 100 peuvent être réalisées telles qu'elles se trouvent dans une configuration en cathode commune, c'est-à-dire dont les cathodes sont reliées, ou couplées, électriquement entre elles. En variante, les LEDs 100 peuvent comporter chacune une cathode 140 qui n'est pas reliée, ou couplée, électriquement aux cathodes 140 des autres LEDs 100.

Une barrière de diffusion, formée par une couche de Ti et une couche de TiN, est réalisée sur les anodes 138 et les cathodes 140 par dépôt, lithographie et gravure.

L'ensemble de la face supérieure de l'ensemble réalisé, qui correspond à une face arrière 141 de la matrice de LEDs 100 au niveau de laquelle les électrodes 138 et 140 des LEDs 100 sont accessibles, est recouvert par un oxyde de collage 142 destiné à la solidarisation ultérieure de la matrice de LEDs 100 avec un circuit électronique de commande.

Parallèlement à la réalisation de la matrice de LEDs 100, le report d'un empilement de couches, destinées à la réalisation de composants du circuit électronique de commande qui sera couplé aux LEDs 100, sur la matrice de LEDs 100 est préparé.

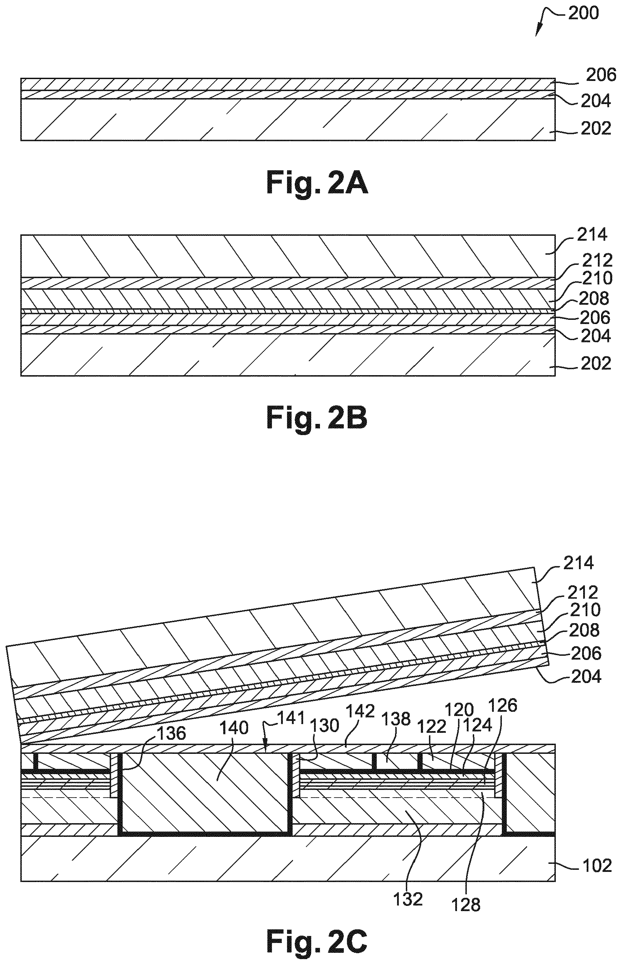

Pour cela, un substrat 200 de type semi-conducteur sur isolant est utilisé (voir figure 2A). Ce substrat 200 comporte une couche épaisse, ou massive, 202 de semi-conducteur, par exemple de silicium, sur laquelle est disposée une couche diélectrique enterrée 204 (BOX), comprenant par exemple du SiO₂. La couche 204 est recouverte d'une couche superficielle 206 de semi-conducteur, comprenant ici du silicium. L'épaisseur de la couche 206 est par exemple comprise entre environ 5 nm et 50 nm, et avantageusement supérieure à environ 30 nm afin d'éviter la mise en œuvre de reprises d'épitaxie ultérieures qui peuvent nécessiter des températures importantes ou un coût technologique additionnel.

De manière avantageuse, la couche 206 comporte du SiGe avec une teneur en germanium comprise entre environ 10 % et 50 %, avantageusement 34%, permettant un bon compromis entre la vitesse de recristallisation par SPER (recristallisation par épitaxie en phase solide, qui sera mise en œuvre ultérieurement) et la simplicité du procédé de fabrication.

La couche 206 correspond à la couche active, c'est-à-dire la couche dans laquelle les zones actives des composants électroniques du circuit électronique de commande qui sera couplé à la matrice de LEDs 100 seront réalisées.

Si les transistors de ce circuit sont en technologie unipolaire, une implantation Vt est possible en pleine plaque au début du procédé de réalisation Dans ce cas, avant de déposer l'empilement de grille décrit plus loin, le substrat 200 peut recevoir une implantation ionique et subir un recuit pleine plaque pour ajuster la tension de seuil des transistors du circuit de commande qui seront réalisés à partir de ce substrat. Cela peut notamment servir à obtenir un compromis entre les fuites et les performances dans ces transistors.

Une couche de diélectrique de grille 208, c'est-à-dire destinée à former les diélectriques de grille des transistors FET du circuit électronique de commande, est formée sur la couche 206. Cette couche 208 comporte par exemple de l'oxyde pouvant être obtenu par oxydation de la couche 206, avec dans ce cas le matériau des diélectriques de grille qui correspond par exemple à du SiO₂, ou par dépôt d'oxyde à haute température HTO (« High Temperature Oxide »). En variante, la couche 208 peut être réalisée par dépôt d'un matériau diélectrique à forte permittivité (« high-k ») tel que du HfO₂.

La réalisation de cette couche 208 est suivie par le dépôt d'une couche de matériau conducteur de grille 210 destinée à former les conducteurs de grille des transistors FET. Lorsque la couche 208 comporte un oxyde de semi-conducteur, le matériau de la couche 210 correspond par exemple à du polysilicium. En variante, lorsque le matériau de la couche 208 est un diélectrique à forte permittivité, le matériau de la couche 210 peut être un empilement de métal tel que du TiN, du TaN, ou encore du TiAIN, etc., et de polysilicium. Le polysilicium de la couche 210 peut être dopé.

Une couche de masque dur 212 est ensuite déposée sur la couche 210. Le matériau de la couche 212 correspond par exemple à un nitrure ou un oxyde de semi-conducteur, et son épaisseur est par exemple comprise entre environ 10 nm et 100 nm.

Une couche de maintien mécanique 214, formant une poignée temporaire, est déposée sur la couche 212 (figure 2B). Cette poignée offre un maintien mécanique de l'empilement de couches réalisé, ce qui permet de supprimer la couche épaisse 202 et accéder à la couche diélectrique enterré 204 depuis la face arrière de cet empilement.

L'ensemble ainsi réalisé est reporté au niveau de la face arrière 141 de la matrice de LEDs 100 précédemment réalisée, un collage direct de type oxyde - oxyde étant réalisé entre la couche diélectrique enterrée 204 et la couche 142 (figure 2C).

Après la mise en œuvre de cet assemblage, le substrat 102 est supprimé, par exemple par retrait par laser (« laser lift-off ») en utilisant la couche 214 comme élément de maintien mécanique de l'ensemble obtenu. Une face avant 143 de la matrice de LEDs 100 est alors accessible.

En parallèle de la mise en œuvre des étapes précédemment décrites, une structure destinée à former des capots pour les LEDs 100 est réalisée.

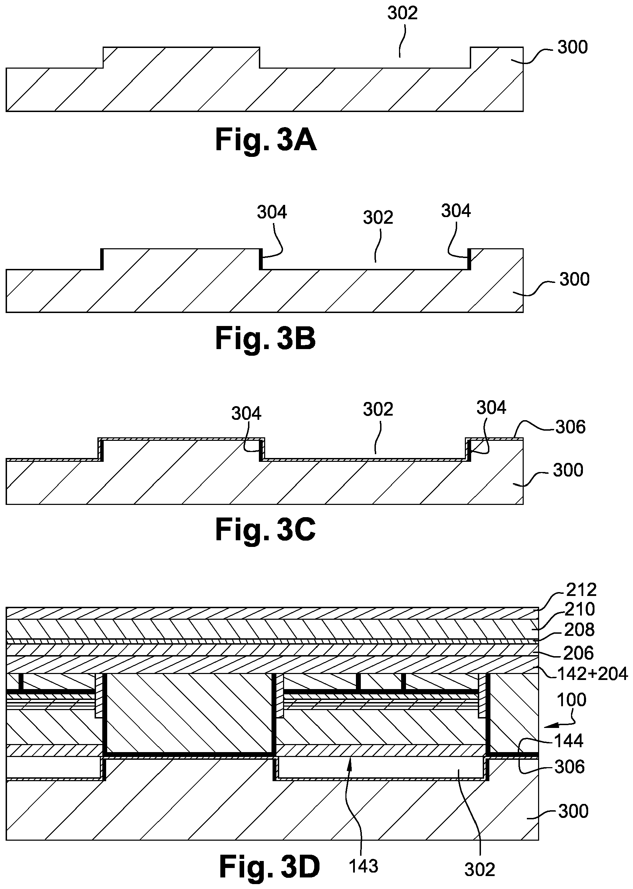

Comme représenté sur la figure 3A, une couche capot 300, correspondant par exemple à un substrat de semi-conducteur, tel que du silicium, est soumis à une lithographie et une gravure dans une partie de son épaisseur pour former des cavités 302 qui sont destinées à être disposées en regard des LEDs 100.

Un matériau optiquement réflecteur (apte à réfléchir une majeure partie de la lumière, par exemple plus de 80 % de la lumière reçue) est ensuite déposé sur la face de la couche capot 300 au niveau de laquelle les cavités 302 ont été réalisées. Ce matériau optiquement réflecteur est gravé afin de ne conserver que des portions 304 de ce matériau optiquement réflecteur disposées contre des parois latérales des cavités 302 (figure 3B). Cette gravure est par exemple une gravure anisotrope RIE ICP.

Une couche de collage 306, comprenant par exemple de l'oxyde de semi-conducteur tel que du SiO₂, est ensuite formée sur l'ensemble de la face de la couche capot 300 comprenant les cavités 302, ainsi que dans les cavités 302 (paroi de fond et parois latérales formées par les portions 304) (figure 3C).

La structure obtenue, destinée à former des capots pour les LEDs 100, est ensuite solidarisée à la face avant 143 de la matrice de LEDs 100, du côté opposé à celui au niveau duquel les électrodes 138 et 140 sont accessibles, telle que les cavités 302 soient disposées face au LEDs 100. La face avant 143 de la matrice de LEDs 100 est préalablement recouverte d'une couche de collage 144 à laquelle la couche de collage 306 est solidarisée.

Un recuit de consolidation peut être mis en œuvre afin de renforcer ce collage entre la matrice de LEDs 100 et les capots.

La couche de maintien mécanique 214 peut ensuite être supprimée (figure 3D), le maintien mécanique de l'ensemble étant assuré par la structure de capots comprenant la couche capot 300.

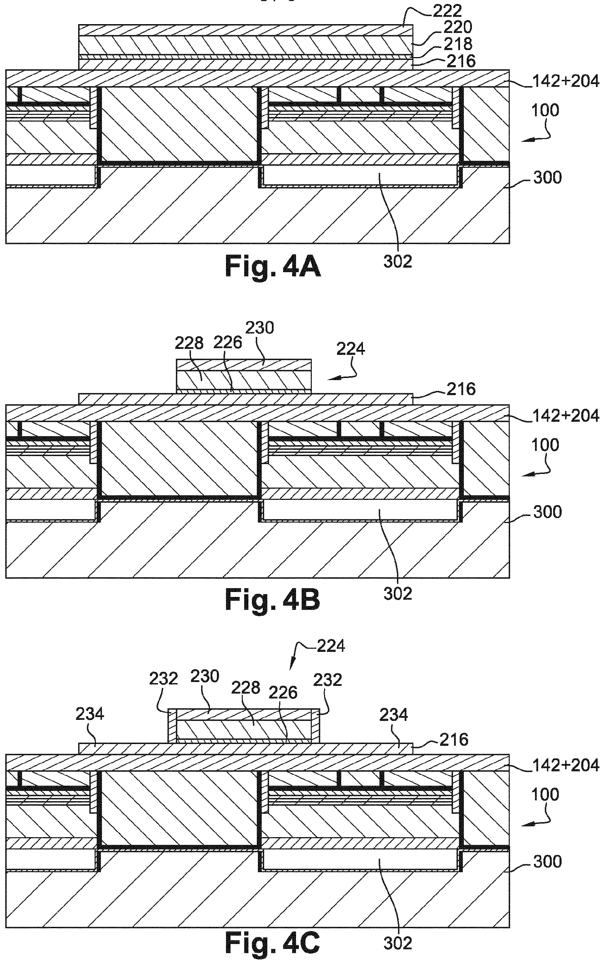

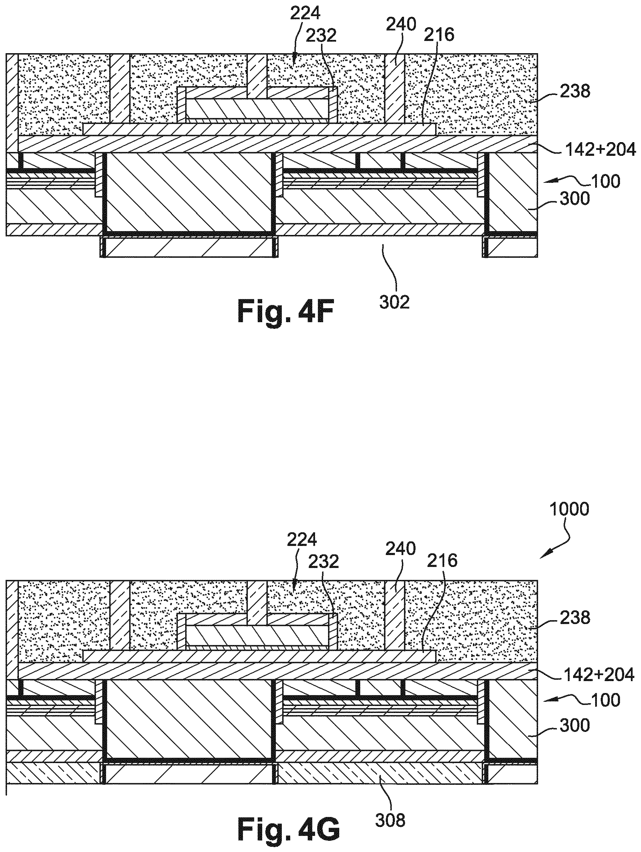

Les couches 212, 210, 208 et 206 sont ensuite gravées afin de définir, dans la couche 206, les zones actives 216 des transistors FET destinés à être formés sur la matrice de LEDs 100. Les portions restantes 218, 220 et 222 des couches 208, 210 et 212 sont gravées selon le même motif que celui des zones actives. Cette gravure est stoppée sur l'oxyde de collage 142+204 (figure 4A).

Sur les figures 4A et suivantes, le rapport entre les dimensions des composants électroniques, notamment des transistors FET, et celles des LEDs 100 représentées ne correspond pas aux dimensions réelles de ces éléments. En outre, sur ces figures, la réalisation d'un seul transistor FET est représentée. Toutefois, pour chaque LED 100, le circuit électronique de commande réalisé peut comporter plusieurs transistors FET associés à cette LED 100.

Comme représenté sur la figure 4B, une autre lithographie et une autre gravure sont mises en œuvre pour former, dans les portions 218, 220 et 222, les grilles des composants électroniques. Des grilles 224 comprenant chacune un diélectrique de grille 226 et une portion conductrice de grille 228 sont ainsi réalisées. Les grilles 224 sont recouvertes d'une portion restante 230 de la couche de masque dur 212 servant à la gravure des grilles 224.

Des espaceurs 232 sont ensuite réalisés autour des grilles 224 et des portions 230, par dépôt et gravure. Les espaceurs 232 sont par exemple réalisés à partir d'un ou plusieurs matériaux diélectriques déposés à basse température tel que du SiCO, SiCBN ou du BN.

Les régions de source et de drain des transistors sont ensuite réalisées dans les parties 234 des zones actives 216 non recouvertes par les grilles 224 et par les espaceurs 232. Pour réaliser ces régions de source et de drain, une implantation ionique dimensionnée de telle sorte à rendre amorphe partiellement le semi-conducteur de ces parties 234 des zones actives 216 est mise en œuvre. Cette amorphisation est partielle car une partie du semi-conducteur cristallin de ces parties 234 est conservée, par exemple sous la forme d'un germe de recristallisation d'épaisseur de l'ordre de 5 nm et disposé du côté de l'oxyde de collage 142+204. Pour la réalisation de transistors NMOS, il est possible d'implanter des ions Sb par exemple avec une énergie comprise entre environ 5 keV et 10 keV et une dose comprise entre environ 5.10¹⁴ at/cm² et 5.10¹⁵ at/cm². Pour la réalisation de transistors PMOS, il est possible d'implanter des ions Ge (par exemple avec une énergie de l'ordre de 5 keV avec une dose de l'ordre de 5.10¹⁴ at/cm²) avant d'implanter des dopants (par exemple du bore avec une énergie de l'ordre de 3 keV et une dose de 8.10¹⁴ at/cm²).

Les conditions d'implantation peuvent être déterminées en utilisant par exemple un simulateur particulaire de type Monte-Carlo pour dimensionner l'épaisseur de la couche de semi-conducteur amorphe.

Un recuit de recristallisation en phase solide est ensuite mis en œuvre à des températures comprises entre environ 450°C et 600°C, formant les sources et drains 236 des transistors FET. Avantageusement, cette température est la plus faible possible. Ce recuit peut être mis en œuvre dans un four, ou bien en utilisant une source laser chauffant localement les régions de source et de drain.

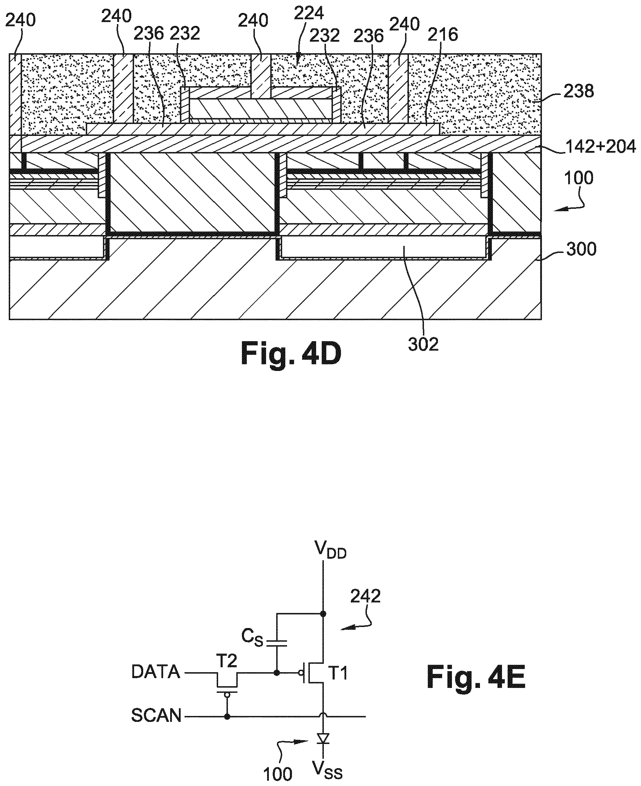

Une couche diélectrique 238 de type PMD (« Pre Metal Dielectric »), comprenant par exemple de l'oxyde de semi-conducteur, est ensuite déposée sur les composants électroniques réalisés, puis planarisée. Des contacts électriques 240, reliés ou couplés notamment aux sources et drains 236 précédemment réalisés ainsi qu'aux grilles 224 et aux électrodes des LEDs 100, sont ensuite réalisés à travers la couche diélectrique 238, et éventuellement les couches diélectrique 142+204 pour les contacts 240 reliés ou couplés aux électrodes des LEDs 100, par gravure et remplissage de matériau électriquement conducteur (figure 4D). Lorsque l'ensemble formé par les couches diélectriques 142+204 a une épaisseur supérieure ou égale à environ 150 nm et/ou si les transistors du circuit électronique de commande sont réalisés avec de faibles dimensions comme par exemple celles adaptées aux nœuds technologiques inférieurs à 65 nm, les contacts électriques 240 peuvent être réalisés en deux étapes : une première étape de lithographie et de gravure formant les emplacements des contacts électriques 240 associés aux source, drain et grille des transistors, et une deuxième étape de gravure formant les emplacements des contacts électriques 240 associés aux LEDs 100. Ces emplacements sont ensuite remplis simultanément pour former l'ensemble des contacts électriques 240.

Le circuit électronique de commande de la matrice de LEDs 100 est achevé en formant, au-dessus de la couche 238, un ou plusieurs niveaux métalliques d'interconnexions (non visibles sur les figures 4D et suivantes).

Le circuit électronique de commande peut correspondre à tout type de circuit électronique de commande apte à piloter l'émission lumineuse des LEDs 100. Un exemple de circuit de commande 242 est représenté sur la figure 4E. En variante, le circuit de commande 242 peut ne pas comporter de capacités, et comporte dans ce cas des transistors supplémentaires formant des points mémoires.

La couche capot 300 est ensuite amincie jusqu'à atteindre les cavités 302 et ainsi ouvrir ces cavités 302 et permettre aux LEDs 100 d'émettre de la lumière (figure 4F). Des portions de la couche capot 300 sont conservées à côté des cavités 302 ouvertes, ce qui permet de limiter le phénomène de diaphonie, ou « crosstalk », entre pixels voisins.

Les espaces formés par les cavités 302 ouvertes peuvent être remplis par des luminophores 308 disposés contre les faces de sortie des LEDs 100 et permettant de modifier les longueurs d'onde émises par les LEDs 100.

Selon un exemple de réalisation particulier, les canaux des transistors FET réalisés peuvent avoir des canaux (réalisés à partir de la couche 206) formés de SiGe à 34% de germanium, d'épaisseur égale à environ 17 nm ce qui permet de réaliser ces transistors FET sans avoir à mettre en œuvre une reprise d'épitaxie et donc d'assurer une réalisation des transistors FET sans jamais dépasser une température d'environ 400°C (température atteinte lors du recuit de recristallisation en phase solide, pendant environ 47h à 400°C dans l'exemple de réalisation particulier décrit ici). Afin d'assurer un bon contrôle électrostatique et de bénéficier d'une pente sous le seuil de l'ordre de 60 mV/dec, la longueur de grille minimale de ces transistors FET peut être de l'ordre de 85 nm. Le courant ON du transistor sera alors d'environ 110 µA/µm, et son courant OFF sera d'environ 5.10⁻¹⁰ A/µm.

En variante, les canaux des transistors FET peuvent être amincis de manière à pouvoir diminuer la longueur de grille tout en bénéficiant d'un bon contrôle électrostatique du transistor. Cette épaisseur des canaux peut être égale à environ 10 nm, ce qui permet d'avoir une longueur de grille de l'ordre de 50 nm (avec dans ce cas I_{ON} de l'ordre de 200 µA/µm et I_{OFF} de l'ordre de 1 nA/µm). Dans ce cas, une épitaxie des sources et drains peut être réalisée à une température d'environ 450°C. L'activation des dopants peut alors être réalisée en mettant en œuvre une amorphisation partielle telle que décrite précédemment, puis un recuit de recristallisation en phase solide SPER de 450°C pendant une durée d'environ 1h10.

En variante du mode de réalisation précédemment décrit, la couche active 206 dans laquelle sont réalisés les canaux des transistors FET du circuit électronique de commande peut comporter du silicium. Cette variante permet la réalisation de transistors NMOS et PMOS sans les contraintes de réalisation de canaux de transistors NMOS dans du SiGe. Par contre, les transistors PMOS ont dans ce cas de moins bonnes performances, les vitesses de recristallisation par SPER sont plus faibles et les reprises d'épitaxies sont réalisées à des températures d'au moins 500°C.

Les épaisseurs des canaux des transistors FET réalisés peuvent être inférieures à 17 nm. Dans ce cas, pour avoir un bon contrôle des effets de canal court, les grilles peuvent avoir des longueurs d'au moins 5 fois l'épaisseur des canaux. En fonction du courant désiré dans les transistors, la longueur des grilles des transistors peut donc être ajustée. En outre, il peut être nécessaire de réaliser une épitaxie des source et drain après avoir gravé la grille et réalisé les espaceurs, par exemple lorsque le canal a une épaisseur égale à environ 10 nm.

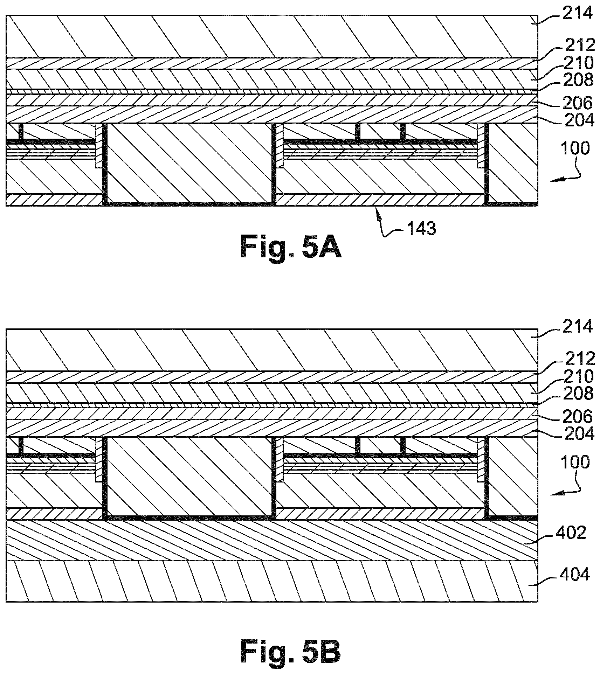

Les figures 5A à 5D représentent les étapes mises en œuvre selon un autre mode de réalisation du dispositif d'affichage 1000. Dans cet autre mode de réalisation, une structure de filtrage optique 400 est réalisée sur la face avant 143 de la matrice de LEDs 100.

Les étapes précédemment décrites en lien avec les figures 1A à 2C sont tout d'abord mises en œuvre.

Comme représenté sur la figure 5A, le substrat 102 est supprimé, par exemple par retrait par laser (« laser lift-off ») en utilisant la couche 214 comme élément de maintien mécanique de l'ensemble obtenu. La face avant 143 de la matrice de LEDs 100 est alors accessible.

Une couche 402 comprenant un premier matériau de filtrage est formée contre la face avant 143 de la matrice de LEDs 100. Cette couche 402 est supportée par un substrat de croissance 404 servant à la réalisation de la couche 402 (figure 5B). Dans l'exemple de réalisation décrit ici, cette couche 402 comporte un premier matériau de filtrage apte à laisser passer les longueurs d'onde correspondant à la couleur verte, c'est-à-dire comprises entre environ 490 nm et 573 nm.

Le substrat de croissance 404 est ensuite retiré puis la couche 402 est gravée afin de ne conserver des portions restantes 406 de cette couche 402 qu'en regard des LEDs 100, par exemple appelées premières LEDs, destinées à émettre une lumière verte.

Une première couche diélectrique transparente, comportant par exemple de l'oxyde, est ensuite déposée puis planarisée afin de remplir les espaces entre ces portions 406. Des portions 408 de matériau diélectrique transparent sont ainsi formées en regard des LEDs 100 qui ne sont pas destinées à émettre une lumière verte.

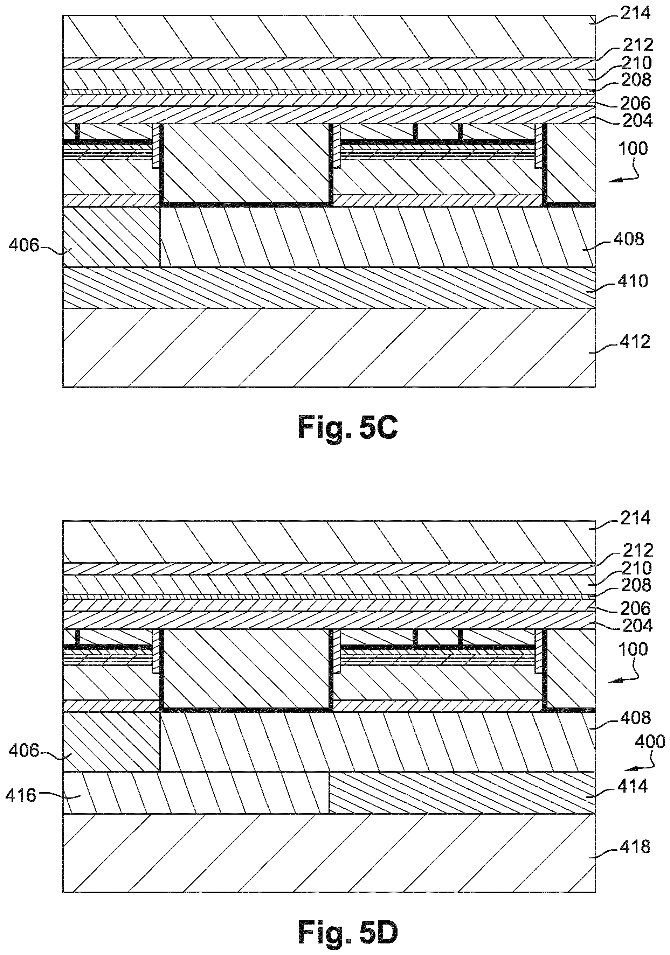

Une couche 410 comprenant un deuxième matériau de filtrage est formée contre les portions 406 et 408. Là encore, cette couche 410 est supportée par un substrat de croissance 412 (figure 5C). Dans l'exemple de réalisation décrit ici, cette couche 410 comporte un deuxième matériau de filtrage apte à laisser passer les longueurs d'onde correspondant à la couleur rouge, c'est-à-dire comprises entre environ 600 nm et 700 nm.

Le substrat de croissance 412 est ensuite retiré puis la couche 410 est gravée afin de ne conserver des portions restantes 414 de cette couche 410 qu'en regard des LEDs 100, par exemple appelées deuxièmes LEDs, destinées à émettre une lumière rouge.

Une deuxième couche diélectrique transparente, comportant par exemple de l'oxyde, est ensuite déposée puis planarisée afin de remplir les espaces entre ces portions 414. Des portions 416 de matériau diélectrique transparent sont ainsi formées en regard des LEDs 100 qui ne sont pas destinées à émettre une lumière rouge.

La structure de filtrage optique 400 selon ce mode de réalisation comporte donc les portions 406, 408, 414 et 416. En variante, il est possible que la structure de filtrage optique 400 comporte un seul niveau de portions de matériau de filtrage, par exemple uniquement les portions 406 et 408. Selon une autre variante, la structure de filtrage optique 400 peut comporter plus de deux niveaux de portions de matériau filtrage, par exemple trois. Par exemple, il est possible que la structure de filtrage optique soit réalisée en utilisant trois matériaux de filtrage différents, par exemple laissant passer uniquement les longueurs d'ondes correspondant aux couleurs rouge, vert ou bleu, les portions de ces matériaux de filtrage étant agencées face aux LEDs 100 en formant une matrice de Bayer ou toute autre configuration de filtrage.

Lorsque la structure de filtrage optique 400 est achevée, une couche de maintien mécanique optiquement transparente 418 est déposée sur la structure de filtrage optique 400 (figure 5D). Cette couche 418 assure un maintien mécanique permettant de supprimer la couche 214. Cette couche 418 est avantageusement un substrat de verre car il est totalement compatible thermiquement avec les températures atteintes lors de la mise en œuvre des étapes ultérieures pour achever la réalisation du dispositif d'affichage 100. De plus, le verre a un coefficient d'expansion thermique similaire à celui du silicium

Le dispositif d'affichage 1000 est ensuite achevé en réalisant le circuit électronique de commande, et notamment les transistors FET, en face arrière de la matrice de LEDs 100, comme précédemment décrit en lien avec les figures 4A à 4D.

## Revendications

1. Procédé de réalisation d'un dispositif d'affichage (1000), comportant au moins la mise en œuvre des étapes suivantes :
- réalisation d'une matrice de LEDs (100) comportant chacune des électrodes (120, 138, 140) accessibles depuis une face arrière (141) de la matrice de LEDs (100) et des surfaces d'émission lumineuse depuis une face avant (143) de la matrice de LEDs (100), puis ;
- solidarisation, sur la face arrière (141) de la matrice de LEDs (100), d'un empilement de couches comprenant au moins une couche de semi-conducteur (206), une couche de diélectrique de grille (208) et une couche de matériau conducteur de grille (210), puis ;
- réalisation, à partir de l'empilement de couches, d'un circuit électronique de commande (242) couplé électriquement aux électrodes (120, 138, 140) des LEDs (100), comprenant la réalisation de transistors FET comprenant des zones actives (216) et des grilles (224), les zones actives (216) étant formées dans la couche de semi-conducteur (206) et les grilles (224) étant formées dans les couches de diélectrique de grille (208) et de matériau conducteur de grille (210).

2. Procédé selon la revendication 1, dans lequel la réalisation de la matrice de LEDs (100) comporte la mise en œuvre des étapes suivantes, pour chacune des LEDs (100) :
- réalisation d'une structure mesa comprenant au moins des première et deuxième portions de semi-conducteur (124, 128, 132) de dopages différents et formant une jonction p-n ;
- réalisation d'une première électrode (120, 138) disposée sur la structure mesa et reliée électriquement à la première portion de semi-conducteur (124) ;
- réalisation d'une deuxième électrode (140) disposée à côté de la structure mesa et reliée électriquement à la deuxième portion de semi-conducteur (128, 132) par l'intermédiaire d'au moins une partie des faces latérales de la deuxième portion de semi-conducteur (132).

3. Procédé selon l'une des revendications précédentes, dans lequel la couche de semi-conducteur (206) comporte du SiGe avec une teneur en germanium comprise entre environ 10 % et 50 %.

4. Procédé selon l'une des revendications précédentes, dans lequel la solidarisation de l'empilement de couches sur la face arrière (141) de la matrice de LEDs (100) comporte la mise en œuvre d'un collage direct entre une première couche d'oxyde (204) faisant partie de l'empilement de couches et une deuxième couche d'oxyde (142) disposée sur la face arrière (141) de la matrice de LEDs (100).

5. Procédé selon la revendication 4, comportant en outre, avant la solidarisation de l'empilement de couches sur la face arrière (141) de la matrice de LEDs (100), la réalisation de l'empilement de couches par la mise en œuvre des étapes suivantes :
- réalisation de la couche de diélectrique de grille (208) sur la couche de semi-conducteur (206) qui correspond à la couche superficielle d'un substrat de type semi-conducteur sur isolant ;
- réalisation de la couche de matériau conducteur de grille (210) sur la couche de diélectrique de grille (208) ;
- réalisation d'une couche de masque dur (212) sur la couche de matériau conducteur de grille (210) ;
- réalisation d'une couche de maintien mécanique (214) sur la couche de masque dur (212) ;
- suppression d'une couche épaisse de semi-conducteur (202) du substrat de type semi-conducteur sur isolant ;
et dans lequel une couche diélectrique enterrée (204) du substrat de type semi-conducteur sur isolant forme la première couche d'oxyde.

6. Procédé selon l'une des revendications précédentes, dans lequel la couche de semi-conducteur (206) de l'empilement de couches comporte un semi-conducteur cristallin, et dans lequel les zones actives (216) des transistors FET sont formées dans la couche de semi-conducteur (206) au moins via la mise en œuvre d'une implantation ionique dans des parties (234) des zones actives (216) des transistors FET destinées à former les source et drain (236) des transistors FET, rendant partiellement amorphe le semi-conducteur desdites parties (234), puis d'un recuit de recristallisation en phase solide des zones actives (216) des transistors FET.

7. Procédé selon la revendication 6, dans lequel le recuit de recristallisation est mis en œuvre à une température comprise entre environ 450°C et 600°C.

8. Procédé selon l'une des revendications 6 ou 7, dans lequel le recuit de recristallisation est mis en œuvre en exposant les source et drain (216) des transistors FET à une source laser.

9. Procédé selon l'une des revendications 6 à 8, dans lequel la réalisation des transistors FET comporte la mise en œuvre des étapes suivantes :
- lithographie et gravure des couches de diélectrique de grille (208) et de matériau conducteur de grille (210) et de la couche de semi-conducteur (206) telles que des portions restantes de la couche de semi-conducteur forment les zones actives (216) des transistors FET ;
- lithographie et gravure des couches de diélectrique de grille (208) et de matériau conducteur de grille (210) telles que des portions restantes (226, 228) des couches de diélectrique de grille (208) et de matériau conducteur de grille (210) forment les grilles (224) des transistors FET ;
- réalisation d'espaceurs (232) contre des parois latérales des grilles (224) des transistors FET ;
et dans lequel les parties (234) des zones actives (216) des transistors FET destinées à former les source et drain (236) des transistors FET correspondent à des parties des zones actives (216) des transistors FET non recouvertes par les grilles (224) et les espaceurs (232).

10. Procédé selon l'une des revendications précédentes, dans lequel la réalisation du circuit électronique de commande (242) comporte en outre, après la réalisation des transistors FET, la réalisation de contacts électriques (240) reliés électriquement aux transistors FET et/ou aux électrodes (120, 138, 140) des LEDs (100).

11. Procédé selon l'une des revendications précédentes, comportant en outre, entre la solidarisation de l'empilement de couches sur la face arrière (141) de la matrice de LEDs (100) et la réalisation du circuit électronique de commande (242), la mise en œuvre des étapes suivantes :
- réalisation de cavités (302) à travers une face d'une couche capot (300), chaque cavité (302) étant destinée à être disposée en regard d'une des LEDs (100) ;
- dépôt d'un matériau réflecteur (304) au moins contre des parois latérales intérieures des cavités (302) ;
- solidarisation de ladite face de la couche capot (300) contre la face avant (143) de la matrice de LEDs (100) telle que chaque cavité (302) soit disposée en regard d'au moins une des LEDs (100) ;
et comportant en outre, après la réalisation du circuit électronique de commande (242), une étape d'amincissement de la couche capot (300) supprimant des parois de fond des cavités (302) de la couche capot (300) se trouvant en regard des surfaces d'émission lumineuse des LEDs (100).

12. Procédé selon la revendication 11, comportant en outre, après l'étape d'amincissement de la couche capot (300), une étape de réalisation de luminophores (308) entre les portions restantes de la couche capot (300), contre la face avant (143) de la matrice de LEDs (100) et en regard des surfaces d'émission des LEDs (100).

13. Procédé selon l'une des revendications 1 à 10, comportant en outre, entre la solidarisation de l'empilement de couches sur la face arrière (141) de la matrice de LEDs (100) et la réalisation du circuit électronique de commande, la réalisation d'une structure de filtrage optique (400) apte à filtrer au moins une partie des longueurs d'onde destinées à être émises par au moins une partie des LEDs (100), sur la face avant (143) de la matrice de LEDs (100) et en regard des surfaces d'émission lumineuse de ladite partie des LEDs (100).

14. Procédé selon la revendication 13, dans lequel la réalisation de la structure de filtrage optique (400) comporte au moins la mise en œuvre des étapes suivantes :
- dépôt d'une couche (402) d'un premier matériau de filtrage sur la face avant (143) de la matrice de LEDs (100) ;
- gravure de la couche (402) du premier matériau de filtrage telle que des portions restantes (406) du premier matériau de filtrage soient disposées en regard des surfaces d'émission lumineuse d'une partie des LEDs (100), appelées premières LEDs ;
- réalisation de premières portions (408) de matériau diélectrique transparent entre les portions restantes (406) du premier matériau de filtrage ;
- dépôt d'une deuxième couche (410) de matériau de filtrage sur les portions restantes (406) du premier matériau de filtrage et sur les premières portions (408) de matériau diélectrique transparent ;
- gravure de la deuxième couche (410) de matériau de filtrage telle que des portions restantes (414) du deuxième matériau de filtrage soient disposées en regard de surfaces d'émission d'autres LEDs (100), appelées deuxième LEDs ;
- réalisation de deuxièmes portions (416) de matériau diélectrique transparent entre les portions restantes (414) du deuxième matériau de filtrage ;
et comportant en outre un dépôt d'une couche (418) de maintien mécanique optiquement transparente contre la structure de filtrage optique (400) préalablement à la réalisation du circuit électronique de commande.

## Patentansprüche

1. Verfahren zur Herstellung einer Anzeigevorrichtung (1000), das zumindest die Ausführung der nachstehenden Schritte umfasst:
- Herstellen einer Matrix aus LEDs (100), die jeweils von einer Rückseite (141) der Matrix aus LEDs (100) zugängliche Elektroden (120, 138, 140) und von einer Vorderseite (143) der Matrix aus LEDs (100) zugängliche lichtemittierende Flächen aufweist; dann
- Verbinden eines Schichtstapels, der zumindest eine Halbleiterschicht (206), eine Schicht aus Gate-Dielektrikum (208) und eine Schicht aus Gate-Leitermaterial (210) umfasst, mit der Rückseite (141) der Matrix aus LEDs (100); dann
- Herstellen einer elektronischen Steuerschaltung (242), die elektrisch mit den Elektroden (120, 138, 140) der LEDs (100) gekoppelt wird, aus dem Stapel von Schichten, umfassend das Herstellen von FET-Transistoren mit aktiven Bereichen (216) und Gates (224), wobei die aktiven Bereiche (216) in der Halbleiterschicht (206) und die Gates (224) in den Schichten aus Gate-Dielektrikum (208) und Gate-Leitermaterial (210) ausgebildet werden.

2. Verfahren nach Anspruch 1,
wobei das Herstellen der Matrix aus LEDs (100) das Ausführen der nachstehenden Schritte für jede der LEDs (100) umfasst:
- Herstellen einer Mesa-Struktur, die zumindest einen ersten und einen zweiten Halbleiterabschnitt (124, 128, 132) mit unterschiedlicher Dotierung umfasst und einen p-n-Übergang bildet;
- Herstellen einer ersten Elektrode (120, 138), die auf der Mesa-Struktur angeordnet und elektrisch mit dem ersten Halbleiterabschnitt (124) verbunden wird;
- Herstellen einer zweiten Elektrode (140), die neben der Mesa-Struktur angeordnet und über zumindest einen Teil der Seitenflächen des zweiten Halbleiterabschnitts (132) elektrisch mit dem zweiten Halbleiterabschnitt (128, 132) verbunden wird.

3. Verfahren nach einem der vorangehenden Ansprüche,
wobei die Halbleiterschicht (206) SiGe mit einem Germaniumgehalt von etwa 10% bis 50% enthält.

4. Verfahren nach einem der vorangehenden Ansprüche,
wobei das Verbinden des Schichtstapels mit der Rückseite (141) der Matrix aus LEDs (100) das Durchführen eines direkten Bondens zwischen einer ersten Oxidschicht (204), die Teil des Schichtstapels ist, und einer zweiten Oxidschicht (142), die an der Rückseite (141) der Matrix aus LEDs (100) angeordnet ist, umfasst.

5. Verfahren nach Anspruch 4,
ferner umfassend vor dem Verbinden des Schichtstapels mit der Rückseite (141) der Matrix aus LEDs (100) das Herstellen des Schichtstapels durch Ausführen der nachstehenden Schritte:
- Herstellen der Schicht aus Gate-Dielektrikum (208) an der Halbleiterschicht (206), die der Oberflächenschicht eines Substrats vom Typ Halbleiter auf Isolator entspricht;
- Herstellen der Schicht aus Gate-Leitermaterial (210) an der Schicht aus Gate-Dielektrikum (208);
- Herstellen einer Hartmaskenschicht (212) an der Schicht aus Gate-Leitermaterial (210);
- Herstellen einer Schicht zum mechanischen Halt (214) an der Hartmaskenschicht (212);
- Entfernen einer dicken Halbleiterschicht (202) von dem Substrat vom Typ Halbleiter auf Isolator;
wobei eine vergrabene dielektrische Schicht (204) des Substrats vom Typ Halbleiter auf Isolator die erste Oxidschicht bildet.

6. Verfahren nach einem der vorangehenden Ansprüche,
wobei die Halbleiterschicht (206) des Schichtstapels einen kristallinen Halbleiter enthält und wobei die aktiven Bereiche (216) der FET-Transistoren in der Halbleiterschicht (206) zumindest dadurch gebildet werden, dass in Teilen (234) der aktiven Bereiche (216) der FET-Transistoren, die Source und Drain (236) der FET-Transistoren bilden sollen, eine Ionenimplantation durchgeführt wird, wobei der Halbleiter der genannten Teile (234) teilweise amorph gemacht wird, und dann ein Festphasen-Rekristallisationsglühen der aktiven Bereiche (216) der FET-Transistoren durchgeführt wird.

7. Verfahren nach Anspruch 6,
wobei das Rekristallisationsglühen bei einer Temperatur im Bereich von etwa 450°C bis 600°C durchgeführt wird.

8. Verfahren nach einem der Ansprüche 6 oder 7,
wobei das Rekristallisationsglühen durchgeführt wird, indem Source und Drain (216) der FET-Transistoren einer Laserquelle ausgesetzt werden.

9. Verfahren nach einem der Ansprüche 6 bis 8,
wobei das Herstellen der FET-Transistoren das Ausführen der nachstehenden Schritte umfasst:
- Lithographie und Ätzen der Schichten aus Gate-Dielektrikum (208) und Gate-Leitermaterial (210) sowie der Halbleiterschicht (206) derart, dass die verbleibenden Abschnitte der Halbleiterschicht die aktiven Bereiche (216) der FET-Transistoren bilden;
- Lithographie und Ätzen der Schichten aus Gate-Dielektrikum (208) und Gate-Leitermaterial (210) derart, dass die verbleibenden Abschnitte (226, 228) der Schichten aus Gate-Dielektrikum (208) und Gate-Leitermaterial (210) die Gates (224) der FET-Transistoren bilden;
- Ausbilden von Spacern (232) an Seitenwänden der Gates (224) der FET-Transistoren;
wobei die Teile (234) der aktiven Bereiche (216) der FET-Transistoren, die Source und Drain (236) der FET-Transistoren bilden sollen, Teilen der aktiven Bereiche (216) der FET-Transistoren entsprechen, die nicht durch die Gates (224) und Spacer (232) abgedeckt sind.

10. Verfahren nach einem der vorangehenden Ansprüche,
wobei das Herstellen der elektronischen Steuerschaltung (242) nach dem Herstellen der FET-Transistoren ferner das Ausbilden von elektrischen Kontakten (240) umfasst, die elektrisch mit den FET-Transistoren und/oder mit den Elektroden (120, 138, 140) der LEDs (100) verbunden werden.

11. Verfahren nach einem der vorangehenden Ansprüche,
ferner umfassend zwischen dem Verbinden des Schichtstapels mit der Rückseite (141) der Matrix aus LEDs (100) und dem Herstellen der elektronischen Steuerschaltung (242) das Ausführen der nachstehenden Schritte:
- Ausbilden von Hohlräumen (302) durch eine Seite einer Deckschicht (300) hindurch, wobei jeder Hohlraum (302) gegenüber einer der LEDs (100) angeordnet werden soll;
- Abscheiden von einem reflektierenden Material (304) zumindest an den inneren Seitenwänden der Hohlräume (302);
- Verbinden der genannten Seite der Deckschicht (300) mit der Vorderseite (143) der Matrix aus LEDs (100) derart, dass jeder Hohlraum (302) zumindest einer der LEDs (100) gegenüberliegend angeordnet wird;
wobei es ferner nach dem Herstellen der elektronischen Steuerschaltung (242) einen Schritt des Verjüngens der Deckschicht (300) umfasst, bei dem Bodenwände der Hohlräume (302) der Deckschicht (300), die den lichtemittierenden Flächen der LEDs (100) gegenüberliegen, entfernt werden.

12. Verfahren nach Anspruch 11,
ferner umfassend nach dem Schritt des Verjüngens der Deckschicht (300) einen Schritt des Ausbildens von Luminophoren (308) zwischen den verbleibenden Abschnitten der Deckschicht (300) an der Vorderseite (143) der Matrix aus LEDs (100) und gegenüber den Emissionsflächen der LEDs (100).

13. Verfahren nach einem der Ansprüche 1 bis 10,
ferner umfassend zwischen dem Verbinden des Schichtstapels mit der Rückseite (141) der Matrix aus LEDs (100) und dem Herstellen der elektronischen Steuerschaltung das Ausbilden einer optischen Filterstruktur (400), die dazu geeignet ist, zumindest einen Teil der Wellenlängen, die von zumindest einem Teil der LEDs (100) emittiert werden sollen, an der Vorderseite (143) der Matrix aus LEDs (100) und gegenüber den lichtemittierenden Flächen dieses Teils der LEDs (100) zu filtern.

14. Verfahren nach Anspruch 13,
wobei das Ausbilden der optischen Filterstruktur (400) zumindest das Ausführen der nachstehenden Schritte umfasst:
- Abscheiden einer Schicht (402) aus einem ersten Filtermaterial auf die Vorderseite (143) der Matrix aus LEDs (100);
- Ätzen der Schicht (402) aus dem ersten Filtermaterial derart, dass die verbleibenden Abschnitte (406) aus dem ersten Filtermaterial gegenüber den lichtemittierenden Flächen eines Teils der LEDs (100), erste LEDs genannt, angeordnet werden;
- Ausbilden von ersten Abschnitten (408) aus transparentem dielektrischem Material zwischen den verbleibenden Abschnitten (406) aus dem ersten Filtermaterial;
- Abscheiden einer zweiten Schicht (410) aus Filtermaterial auf die verbleibenden Abschnitte (406) aus dem ersten Filtermaterial und auf die ersten Abschnitte (408) aus transparentem dielektrischem Material;
- Ätzen der zweiten Schicht (410) aus Filtermaterial derart, dass die verbleibenden Abschnitte (414) aus dem zweiten Filtermaterial gegenüber den Emissionsflächen weiterer LEDs (100), zweite LEDs genannt, angeordnet werden;
- Ausbilden von zweiten Abschnitten (416) aus transparentem dielektrischem Material zwischen den verbleibenden Abschnitten (414) aus dem zweiten Filtermaterial;
wobei es ferner das Abscheiden einer optisch transparenten Schicht zum mechanischen Halt (418) auf die optische Filterstruktur (400) vor dem Herstellen der elektronischen Steuerschaltung umfasst.

## Claims

1. Method of making a display device (1000) comprising at least implementation of the following steps:
- fabricate a matrix of LEDs (100) each comprising electrodes (120, 138, 140) accessible from a back face (141) of the matrix of LEDs (100) and light emitting surfaces from a front face (143) of the matrix of LEDs (100), then;
- securing a stack of layers comprising at least one semiconducting layer (206), a gate dielectric layer (208) and a layer of gate conducting material (210), onto the back face (141) of the matrix of LEDs (100), then;
- starting from the stack of layers, fabricate an electronic control circuit (242) electrically coupled to the electrodes (120, 138, 140) of the LEDs (100), including the fabrication of FET transistors comprising active zones (216) and gates (224), the active zones (216) being formed in the semiconducting layer (206) and the gates (224) being formed in the gate dielectric layer (208) and in the layer of gate conducting material (210).

2. Method according to claim 1, in which the step to make the matrix of LEDs (100) comprises the following steps, for each of the LEDs (100):
- fabricate a mesa structure comprising at least first and second semiconducting portions (124, 128, 132) with different doping and forming a p-n junction;
- fabricate a first electrode (120, 138) located on the mesa structure and electrically coupled to the first semiconducting portion (124);
- fabricate a second electrode (140) located at the side of the mesa structure and electrically coupled to the second semiconducting portion (128, 132) through at least part of the lateral faces of the second semiconducting portion (132).

3. Method according to one of previous claims, in which the semiconducting layer (206) comprises SiGe with a germanium content of between about 10% and 50%.

4. Method according to one of previous claims, in which securing the stack of layers on the back face (141) of the matrix of LEDs (100) comprises implementation of direct bonding between a first oxide layer (204) forming part of the stack of layers and a second oxide layer (142) located on the back face (141) of the matrix of LEDs (100).

5. Method according to claim 4, also comprising fabrication of the stack of layers by implementation of the following steps, before securing the stack of layers on the back face (141) of the matrix of LEDs (100):
- fabricate the gate dielectric layer (208) on the semiconducting layer (206) that corresponds to the surface layer of a semiconductor on insulator type substrate;
- fabricate the layer of gate conducting material (210) on the gate dielectric layer (208),
- fabricate a hard mask layer (212) on the layer of gate conducting material (210);
- fabricate a mechanical support layer (214) on the hard mask layer (212);
- eliminate a thick layer of semiconductor (202) of the semiconductor on insulator type substrate;
and in which a buried dielectric layer (204) of the semiconductor on insulator type substrate forms the first oxide layer.

6. Method according to one of previous claims, in which the semiconducting layer (206) of the stack of layers comprises a crystalline semiconductor, and in which the active zones (216) of the FET transistors are formed in the semiconducting layer (206) at least through an ion implantation in the parts (234) of active zones (216) of FET transistors that will form the source and drain regions (236) of FET transistors, making the semiconductor in said parts (234) partially amorphous, followed by a recrystallisation annealing in the solid phase of the active zones (216) of the FET transistors.

7. Method according to claim 6, in which the recrystallisation annealing is implemented at a temperature between about 450°C and 600°C.

8. Method according to one of claims 6 or 7, in which the recrystallisation annealing is implemented by exposing the source and drain (216) of the FET transistors to a laser source.

9. Method according to one of claims 6 to 8, in which the fabrication of FET transistors includes the following steps:
- lithography and etching of the gate dielectric layer (208) and the gate conducting material layer (210) and the semiconducting layer (206) such that remaining portions of the semiconducting layer form the active zones (216) of the FET transistors;
- lithography and etching of the gate dielectric layer (208) and the layer of gate conducting material (210) such that remaining portions (226, 228) of the gate dielectric layer (208) and the layer of gate conducting material (210) form the gates (224) of the FET transistors;
- fabricate spacers (232) in contact with the lateral walls of the gates (224) of the FET transistors;
and in which the parts (234) of active zones (216) of FET transistors that will form the source and drain (236) of FET transistors correspond to parts of the active zones (216) of FET transistors not covered by the gates (224) and the spacers (232).

10. Method according to one of previous claims, in which fabrication of the electronic control circuit (242) also comprises fabrication of electrical contacts (240) electrically coupled to the FET transistors and/or to the electrodes (120, 138, 140) of the LEDs (100), after fabrication of the FET transistors.

11. Method according to one of previous claims, also comprising implementation of the following steps, between securing the stack of layers on the back face (141) of the matrix of LEDs (100) and fabrication of the electronic control circuit (242):
- fabricate cavities (302) through one face of a cap layer (300), each cavity (302) being intended to face one of the LEDs (100);
- deposit a reflecting material (304) at least in contact with the inner lateral walls of the cavities (302);
- securing said face of the cap layer (300) in contact with the front face (143) of the matrix of LEDs (100) such that each cavity (302) is facing at least one of the LEDs (100);
and also comprising a step after fabrication of the electronic control circuit (242) to thin the cap layer (300), eliminating bottom walls of cavities (302) in the cap layer (300) facing the light emitting surfaces of the LEDs (100).

12. Method according to claim 11, also comprising a step, after the cap layer (300) thinning step, to fabricate phosphors (308) between remaining portions of the cap layer (300), in contact with the front face (143) of the matrix of LEDs (100) and facing the emission surfaces of the LEDs (100).

13. Method according to one of claims 1 to 10, also comprising a step between securing the stack of layers on the back face (141) of the matrix of LEDs (100) and fabrication of the electronic control circuit, to fabricate an optical filter structure (400) to filter at least part of the wavelengths that will be emitted by at least some of the LEDs (100) on the front face (143) of the matrix of LEDs (100) and facing the light emitting surfaces of said some of the LEDs (100).

14. Method according to claim 13, in which the step to make the optical filter structure (400) comprises at least implementation of the following steps:
- deposit a layer (402) of a first filter material on the front face (143) of the matrix of LEDs (100);
- etch the layer (402) of the first filter material such that remaining portions (406) of the first filter material are facing the light emitting surfaces of some of the LEDs (100), called the first LEDs;
- fabricate first portions (408) of transparent dielectric material between the remaining portions (406) of the first filter material;
- deposit a second layer (410) of filter material on the remaining portions (406) of the first filter material and on the first portions (408) of transparent dielectric material;
- etch the second layer (410) of the filter material such that the remaining portions (414) of the second filter material are facing the emitting surfaces of other LEDs (100), called second LEDs;
- fabricate second portions (416) of transparent dielectric material between the remaining portions (414) of the second filter material;
and also comprising a deposition of an optically transparent mechanical support layer (418) in contact with the optical filter structure (400) before fabrication of the electronic control circuit.
